# EUROPEAN PATENT APPLICATION

(11) **EP 2 634 805 A1**
(43) Date of publication of application: **04.09.2013**
(21) Application number: 13157172.1
(22) Date of filing: 28.02.2013
(51) Int. Cl.: H01L 25/075, H01L 33/54

(54) **Light-emitting device assembly and lighting device**

(30) Priority: 02.03.2012 JP 2012046876; 17.07.2012 JP 2012158620
(71) Applicant: NITTO DENKO CORPORATION, Ibaraki-shi, Osaka 567-8680 (JP)
(72) Inventor: Ooyabu, Yasunari, Osaka, 567-8680 (JP); Katayama, Hiroyuki, Osaka, 567-8680 (JP); Umetani, Shigehiro, Osaka, 567-8680 (JP); Ito, Hisataka, Osaka, 567-8680 (JP); Wakiya, Shinsuke, Osaka, 532-8550 (JP)
(74) Representative: HOFFMANN EITLE

(57) **Abstract**

A light-emitting device assembly includes a plurality of light-emitting devices. The plurality of light-emitting devices each includes a circuit board including a pair of electrodes to be connected to an external power source, and to which an electric power is supplied from the power source through the electrodes; a semiconductor element supported on and electrically connected to the circuit board; and an encapsulating layer that encapsulates the semiconductor element on the circuit board. The plurality of light-emitting devices are disposed so as to be continuous in one direction. The encapsulating layer is disposed so that the encapsulating layers of the light-emitting devices next to each other are in contact with each other when viewed from the top.

## Description

### BACKGROUND OF THE INVENTION

### Field of the Invention

The present invention relates to a light-emitting device assembly and a lighting device, in particular to a light-emitting device assembly in which a plurality of light-emitting devices are disposed continuously in one direction, and a lighting device produced by using the light-emitting device assembly.

### Description of Related Art

It has been known that light-emitting diode devices are produced by disposing a single or a plurality of light-emitting diode (LED) elements on a substrate, and encapsulating the LED elements with an encapsulating resin layer.

To be specific, for example, Japanese Unexamined Patent Publication No. 2008-227412 has proposed a light-emitting device having a light-emission portion. In the light-emission portion, a plurality of linear wiring patterns are disposed and formed parallely on an insulating substrate, and a plurality of light emitting elements are mounted within the wiring pattern while electrically connected thereto; and the light-emission portion is encapsulated with an encapsulator.

### SUMMARY OF THE INVENTION

Meanwhile, size and cost reduction of such a light-emitting device has been demanded. However, in the light-emitting device described in Japanese Unexamined Patent Publication No. 2008-227412, the light-emission portion is defined at a more inner side than the peripheral end edge of the insulating substrate. To be specific, when viewed from the top, the light-emission portion is disposed inside the insulating substrate so that the peripheral end edge of the encapsulator and the peripheral end edge of the insulating substrate are not in contact.

In the region at an outer side than the light-emission portion, on the insulating substrate, a pair of electrodes (positive electrode external connection land and negative electrode external connection land) is directly provided, and connection wires connect between these electrodes and a power source. Thus, there are limitations for size and cost reduction.

An object of the present invention is to provide a light-emitting device assembly that allows for size and cost reduction of light-emitting devices, and a lighting device produced by using the light-emitting device assembly.

A light-emitting device assembly of the present invention is a light-emitting device assembly including a plurality of light-emitting devices, the plurality of light-emitting devices each including:
a circuit board including a pair of electrodes to be connected to an external power source, and to which an electric power is supplied from the power source through the electrodes;
a semiconductor element supported on and electrically connected to the circuit board; and
an encapsulating layer that encapsulates the semiconductor element on the circuit board,
wherein the plurality of light-emitting devices are disposed so as to be continuous in one direction, and the encapsulating layer is disposed so that the encapsulating layers of the light-emitting devices next to each other are in contact with each other when viewed from the top.

In such a light-emitting device assembly, the plurality of light-emitting devices are disposed in one direction continuously, and the encapsulating layers of the light-emitting devices next to each other are disposed to be in contact with each other.

That is, in such a light-emitting device assembly, disposition is made such that at least one point of the end edge of the encapsulating layer in one light-emitting device confronts the end edge of the circuit board of the light-emitting device, and in this manner, the encapsulating layers of the light-emitting devices next to each other are in contact.

Thus, for example, compared with the case where the formation is made such that the end edge of the encapsulating layer does not confront the end edge of the circuit board, the region for forming the electrodes, that is, the region at the outside of the encapsulating layer in the circuit board can be made smaller.

Therefore, the area (amount used) of the circuit board per one light-emitting device can be reduced, allowing for size and cost reduction.

In the light-emitting device assembly of the present invention, it is preferable that the encapsulating layer has at least one side when viewed from the top, and the encapsulating layers of the light-emitting devices next to each other are disposed so as to make a line contact at the one side.

In such a light-emitting device assembly, one side of the end edge of the encapsulating layer in one light-emitting device is disposed so as to confront the one side of the end edge of the circuit board of the light-emitting device, and in this manner, the encapsulating layers of the light-emitting devices next to each other make a line contact at the one side.

Thus, for example, compared with the case where the end edge of the encapsulating layer is formed so as to confront at one point thereof with the end edge of the circuit board, the region for forming the electrodes, that is, the region outside the encapsulating layer in the circuit board can be further reduced.

Therefore, the area (amount used) of the circuit board per one light-emitting device can be further reduced, allowing for size and cost reduction.

In the light-emitting device assembly of the present invention, it is preferable that the encapsulating layer has a generally polygonal shape when viewed from the top.

When the encapsulating layer has a generally polygonal shape when viewed from the top, the encapsulating layer can be cut out and formed from a sheet with an excellent yield. Therefore, cost reduction can be achieved.

In the light-emitting device assembly of the present invention, it is preferable that the encapsulating layer has a (4+2n)-gon (n is a natural number including 0) when viewed from the top.

When the encapsulating layer has the (4+2n)-gon (n is a natural number including 0) shape, the encapsulating layer is highly symmetric, and therefore excellent light directivity can be ensured.

In the light-emitting device assembly of the present invention, it is preferable that the encapsulating layer has a generally regular hexagonal shape when viewed from the top.

When the encapsulating layer has a generally regular hexagonal shape when viewed from the top, for example, compared with the case where the encapsulating layer is a regular square, the encapsulating layer can be disposed with good efficiency per one circuit board. Therefore, the encapsulating layer can be formed by cutting out from the sheet with an excellent yield. Thus, a further low cost can be achieved.

A lighting device of the present invention includes at least one of the light-emitting device of the above-described light-emitting device assembly.

Such a lighting device can be produced from the above-described light-emitting device assembly, thus allowing for size and cost reduction.

### BRIEF DESCRIPTION OF THE DRAWINGS

FIG. 1 shows a schematic diagram of an embodiment (embodiment in which an encapsulating layer is formed into a generally regular hexagonal shape when viewed from the top) of the light-emitting device assembly of the present invention,
   FIG. 1(a) illustrating a plan view before encapsulation by the encapsulating layer,
   FIG. 1(b) illustrating a plan view after encapsulation by the encapsulating layer, and
   FIG. 1(c) illustrating a cross-sectional view taken along line A-A' in (b).
FIG. 2 is a production process diagram illustrating a method for producing a light-emitting device assembly shown in FIG. 1,
   FIG. 2(a) illustrating a step of mounting light-emitting diodes on a circuit board, and preparing a resin sheet,
   FIG. 2(b) illustrating a step of covering the light-emitting diodes with the encapsulating resin layer,
   FIG. 2(c) illustrating a step of pressure bonding the resin sheet, and
   FIG. 2(d) illustrating a step of curing the encapsulating resin layer.
FIG. 3 is a plan view illustrating an embodiment in which the light-emitting device assembly shown in FIG. 1 is formed in a plural number continuously.
FIG. 4 is a plan view illustrating another embodiment (embodiment in which the encapsulating layer is formed into a generally regular octagonal shape when viewed from the top) of the light-emitting device assembly of the present invention.
FIG. 5 is a plan view illustrating another embodiment (embodiment in which the encapsulating layer is formed into a generally regular decagonal shape when viewed from the top) of the light-emitting device assembly of the present invention.
FIG. 6 is a plan view illustrating another embodiment (embodiment in which the encapsulating layer is formed into a generally regular dodecagonal shape when viewed from the top) of the light-emitting device assembly of the present invention.
FIG. 7 is a plan view illustrating another embodiment of the light-emitting device assembly of the present invention (embodiment in which the encapsulating layer is formed into a generally rectangular shape when viewed from the top, and external electrodes are formed so as to sandwich the encapsulating layer).
FIG. 8 is a plan view illustrating an embodiment in which the light-emitting device assembly shown in FIG. 7 is formed in a plural number continuously.
FIG. 9 is a plan view illustrating another embodiment (embodiment in which the encapsulating layer is formed into a generally rectangular shape when viewed from the top, and external electrodes are formed so as not to sandwich the encapsulating layer) of the light-emitting device assembly of the present invention.
FIG. 10 is a schematic plan view illustrating an embodiment in which the light-emitting device assembly shown in FIG. 9 is formed in a plural number continuously.
FIG. 11 is a plan view illustrating individually separated light-emitting devices.
FIG. 12 is a plan view illustrating light-emitting devices separated by groups of a plurality of light-emitting devices.

### DETAILED DESCRIPTION OF THE INVENTION

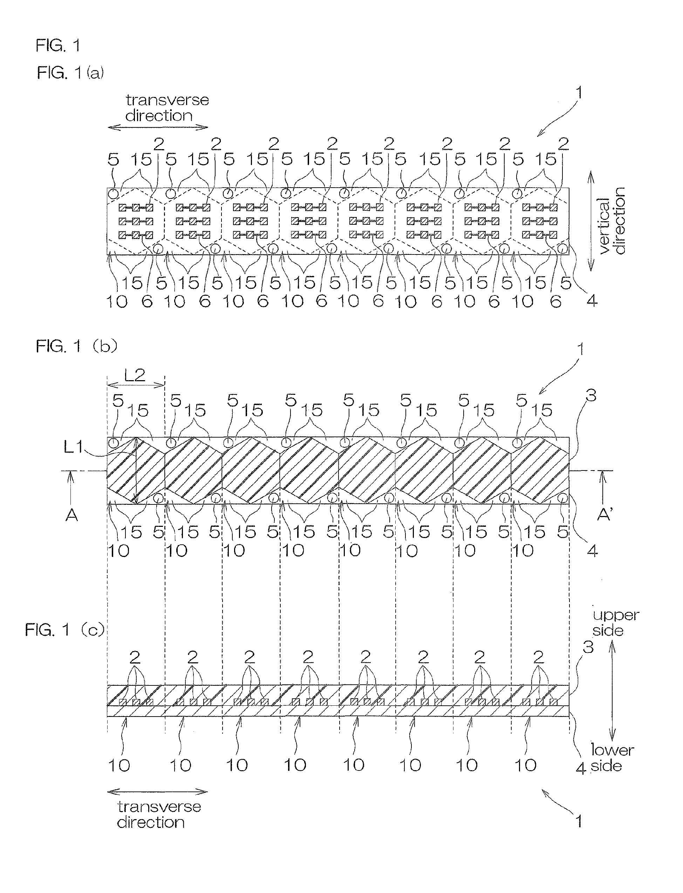

FIG. 1 shows a schematic diagram of an embodiment (embodiment in which the encapsulating layer is formed into a generally regular hexagonal shape when viewed from the top) of the light-emitting device assembly of the present invention; FIG. 1 (a) illustrating a plan view before encapsulation by the encapsulating layer, FIG. 1 (b) illustrating a plan view after encapsulation by the encapsulating layer, and FIG. 1 (c) illustrating a cross-sectional view taken along line A-A' in FIG. 1 (b).

In FIG. 1 (a), the position at which an encapsulating layer 3 described later is disposed is shown by broken line, and in FIG. 1 (b) and FIG. 1 (c), a wire 6 described later is omitted.

In FIG. 1, a light-emitting device assembly 1 is formed by integral continuation of a plurality of (e.g., eight) light-emitting devices 10.

In the description below, directions mentioned are based on the case where the light-emitting device assembly 1 is placed horizontally; up-down direction on the plane of the sheet in FIG. 1 (a) is regarded as vertical direction; and left-right directions on the plane of the sheet in FIG. 1 (a) is regarded as transverse direction. The horizontal direction includes the vertical direction and the transverse direction. The up-down direction on the plane of the sheet in FIG. 1 (c) is regarded as the up-down direction.

The light-emitting devices 10 each includes a circuit board 4; light-emitting diode elements 2 as semiconductor elements supported on the circuit board 4 and electrically connected to the circuit board 4; and an encapsulating layer 3 that encapsulates the light-emitting diode elements 2 on the circuit board 4.

A plurality of (eight) circuit boards 4 are provided to correspond to the light-emitting devices 10, and are shaped into a generally rectangular flat plate when viewed from the top extending in the vertical direction and the transverse direction. The plurality of (eight) circuit boards 4 are formed integrally so as to be continuous in the transverse direction. For the circuit board 4, those substrates generally used for optical semiconductor devices, including, for example, a substrate of ceramic such as alumina, a substrate of resin such as polyimide, and a metal core substrate in which metals are used in the core, may be used.

The circuit board 4 includes, on the top surface thereof, a wiring pattern which is not shown; external electrodes 5 as a pair of electrodes connected to an external power source (not shown); and internal electrodes (not shown) electrically connected to the light-emitting diode element 2.

The external electrodes 5 are, to be described in detail later, as shown in FIG. 1 (b), provided in a plural number (a pair) in a region outside the encapsulating layer 3 (described later) laminated on the circuit board 4, and are disposed oppositely so as to sandwich the encapsulating layer 3.

To the circuit board 4 (wiring pattern (not shown)), an electric power from the power source is supplied through the external electrodes 5, and the electric power is supplied to the light-emitting diode element 2 through the internal electrodes (not shown).

The light-emitting diode element 2 is formed into a generally rectangular flat plate shape when viewed from the top, and on the top surface of the circuit board 4, the plurality (three) of the light-emitting diode elements 2 are disposed parallely in the transverse direction in spaced-apart relation to each other, and the plurality (three rows) of the light-emitting diode elements 2 are disposed parallely in the vertical direction in spaced-apart relation to each other.

Such a light-emitting diode element 2 is electrically connected in series to a light-emitting diode element 2 adjacent to each other in the transverse direction through a wire 6, and is electrically connected to the internal electrodes, which are not shown. Such a light-emitting diode element 2 emits light by the electric power supply from the circuit board 4.

The length of a side of the light-emitting diode element 2 is, for example, 0.1 to 5 mm. The light-emitting diode element 2 has a thickness of, for example, 10 to 1,000 µm.

The gap between the light-emitting diode elements 2 in the vertical direction and the transverse direction is, for example, 0.1 to 20 mm, preferably 0.5 to 5 mm.

The encapsulating layer 3 is a resin layer for encapsulating the light-emitting diode element 2 on the circuit board 4, and is formed into a shape so that when viewed from the top, at least one point of the end edge of the encapsulating layer 3 confronts the end edge of the circuit board 4.

Such an encapsulating layer 3 is formed, as shown in FIG. 1 (b), into a shape having at least one side when viewed from the top, to be more specific, into a generally polygonal shape when viewed from the top, i.e., a generally regular hexagonal shape when viewed from the top.

When the encapsulating layer 3 is a generally polygonal shape when viewed from the top, the encapsulating layer 3 can be cut out and formed from a sheet with an excellent yield. Therefore, cost reduction can be achieved.

That is, in production of the light-emitting device assembly 1, the encapsulating layer 3 is usually produced as a large sheet, and is cut into a suitable size to be used.

In such a case, when the encapsulating layer 3 is formed, for example, into a generally circular shape when viewed from the top, or a generally semi-circular shape when viewed from the top, at a portion outside the circle (or semi-circle), a portion that is not cut out as the encapsulating layer 3, that is, loss is caused.

On the other hand, when the encapsulating layer 3 is formed into a polygonal shape when viewed from the top, the encapsulating layer 3 can be taken out from a large sheet leaving no space (e.g., honey-comb form), the loss can be suppressed, the encapsulating layer 3 can be used without waste, and cost reduction can be achieved.

The regular hexagonal shape when viewed from the top is a (4+2n)-gon (n is a natural number including 0) shape when viewed from the top, that is, a symmetrical polygonal shape.

When the encapsulating layer 3 has a (4+2n)-gon (n is a natural number including 0) shape, the encapsulating layer 3 is highly symmetric, and allows for ensuring of excellent light directivity.

To be more specific, when the encapsulating layer 3 is polygonal shape having angles of an odd number (e.g., triangle, pentagon, heptagonal, etc.) when viewed from the top, the encapsulating layer 3 is symmetric only relative to one direction when viewed from the top.

In contrast, when the encapsulating layer 3 has a (4+2n)-gon (n is a natural number including 0) shape, that is, a polygonal shape having angles of an even number when viewed from the top (e.g., regular hexagonal shape), the encapsulating layer 3 is symmetric in both of the one direction and a direction perpendicular to the one direction (vertical and transverse directions on the plane of the sheet FIG. 1 (b)) when viewed from the top. That is, compared with the case where the encapsulating layer 3 is symmetric in one direction as described above, the encapsulating layer 3 is highly symmetric, and therefore, excellent light directivity can be ensured.

Examples of the (4+2n)-gon (n is a natural number including 0) shape when viewed from the top, that is, a symmetrical polygonal shape, include, in addition to the regular hexagonal shape shown in FIG. 1 (b), for example, polygonal shapes such as rectangular, hexagonal (other than the regular hexagonal shape), octagonal, decagonal, and dodecagonal shapes when viewed from the top.

In particular, when the encapsulating layer 3 is a generally regular hexagonal shape when viewed from the top, for example, compared with the case where the encapsulating layer 3 is a regular square, the encapsulating layer 3 can be disposed with high efficiency per one circuit board 4. Therefore, the encapsulating layer 3 can be cut out and formed from a sheet with an excellent yield. Thus, a further low cost can be achieved.

When the encapsulating layer 3 is formed into a regular hexagonal shape when viewed from the top, and the circuit board 4 is formed into a generally rectangular shape when viewed from the top, as shown in FIG. 1 (b), the encapsulating layer 3 is formed so that the longest diagonal line L1 is the same as the length of one side (side extending in the vertical direction) of the circuit board 4. The encapsulating layer 3 is formed so that distance L2 between the sides facing each other is the same as the length of another side of the circuit board 4 (side extending in the transverse direction).

Of the surfaces of the circuit board 4, the encapsulating layer 3 is laminated on the surface on which the light-emitting diode elements 2 are mounted, so as to cover the light-emitting diode element 2, and in this manner, the encapsulating layer 3 is disposed so that two points (apex of two angles bending toward vertical directions) and two sides (two sides extending in vertical directions) of the encapsulating layer 3 inscribe in the circuit board 4 of the light-emitting device 10.

By disposing the encapsulating layer 3 in this manner, exposed portions 15, i.e., regions that are not encapsulated by the encapsulating layer 3, are defined outside the encapsulating layer 3.

The exposed portions 15 are defined, to be more specific, into a generally triangular shape when viewed from the top, surrounded by the periphery of the circuit board 4 and by one side of the encapsulating layer 3, at four corners, i.e., on both sides in the vertical direction and on both sides in the transverse direction, of the circuit board 4. The exposed portion 15 is defined so that the exposed portions 15 of the light-emitting devices 10 next to each other continue in the transverse direction.

On the exposed portions 15 defined in one light-emitting device 10, two external electrodes 5 are disposed oppositely so as to sandwich the encapsulating layer 3: one on the exposed portion 15 of one side in the vertical direction and one side in the transverse direction, and one on the exposed portion 15 of the other side in the vertical direction and the other side in the transverse direction.

In such a light-emitting device assembly 1, the encapsulating layer 3 is formed integrally so that a plurality (eight) of the encapsulating layers 3 are continuous to each other.

In such a light-emitting device assembly 1, the plurality of light-emitting devices 10 are disposed continuously in one direction, and the encapsulating layers 3 of the light-emitting devices 10 next to each other are in contact at at least one point, to be specific, are making a line contact at one side thereof when viewed from the top.

That is, in such a light-emitting device assembly 1, at least one point of the end edge of the encapsulating layer 3 of one light-emitting device 10 is disposed so as to confront the end edge of the circuit board 4 of the light-emitting device 10, and in this manner, the encapsulating layers 3 of the light-emitting devices 10 next to each other make a contact at at least one point.

Thus, for example, compared with the case where the end edge of the encapsulating layer 3 is formed so as not to confront the end edge of the circuit board 4, the region for forming the external electrodes 5, that is, the region outside the encapsulating layer 3 of the circuit board 4 can be reduced.

Therefore, the area (amount used) of the circuit board 4 relative to one light-emitting device 10 can be reduced, allowing for size and cost reduction.

In particular, in the light-emitting device assembly 1, one side of the end edge of the encapsulating layer 3 in one light-emitting device 10 is disposed so as to confront one side of the end edge of the circuit board 4 of the light-emitting device 10, and in this manner, the encapsulating layers 3 of the light-emitting devices 10 next to each other are making a line contact at one side.

Thus, for example, compared with the case where the end edge of the encapsulating layer 3 is formed so as to confront the end edge of the circuit board 4 at one point, the region for forming the external electrodes 5, that is, the region outside the encapsulating layer 3 in the circuit board 4 can be further reduced.

Therefore, the area (amount used) of the circuit board 4 relative to one light-emitting device 10 can be further reduced, allowing for size and cost reduction.

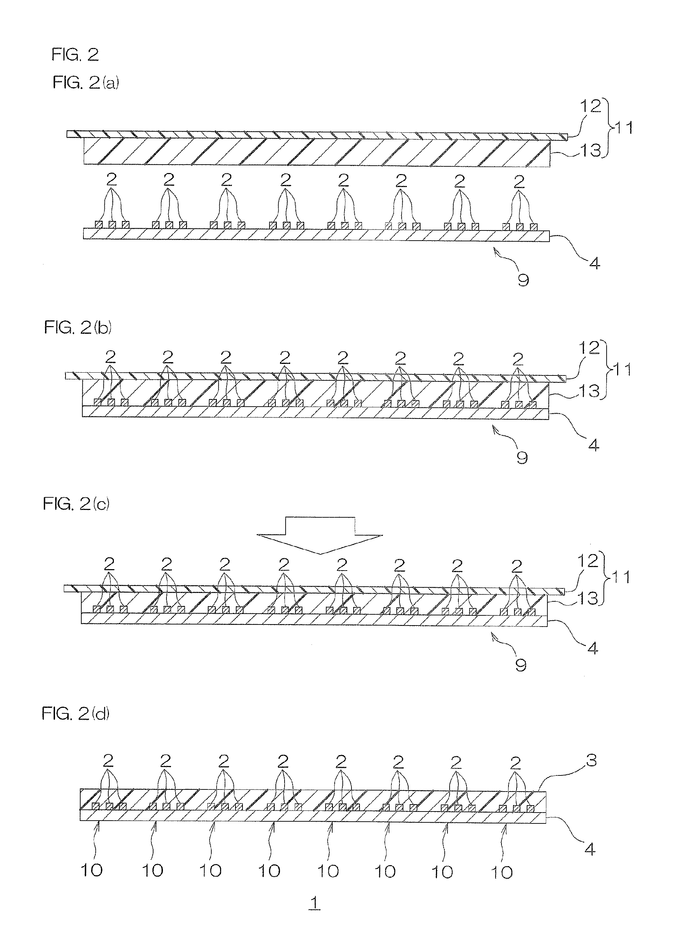

FIG. 2 is a production process diagram illustrating a method for producing the light-emitting device assembly shown in FIG. 1.

In the following figures, members corresponding to the above-described elements are designated with the same reference numerals, and detailed descriptions thereof are omitted.

A method for producing a light-emitting device assembly 1 is described next with reference to FIG. 2.

To produce a light-emitting device assembly 1, first, as shown in FIG. 2 (a), a plurality of the above-described light-emitting diode elements 2 are mounted on the above-described circuit board 4, thereby producing a semiconductor substrate 9.

To produce the light-emitting device assembly 1, separately, a resin sheet 11 as an encapsulating sheet is prepared.

The resin sheet 11 is, as shown in FIG. 2 (a), formed into a sheet, and includes a release film 12, and an encapsulating resin layer 13 laminated on the release film 12 and having generally the same shape as that of the above-described encapsulating layer 3.

The release film 12 is formed, for example, from a resin film such as a polyethylene terephthalate film, polystyrene film, polypropylene film, polycarbonate film, acrylic film, silicone resin film, styrene resin film, and fluorine resin film. The surface of the release film 12 may be treated for release.

The release film 12 has a thickness of, for example, 20 to 100 µm, preferably 30 to 50 µm. When the release film 12 has a thickness within the above-described range, increase in costs can be suppressed, and excellent handling characteristics (handling characteristics at the time of removing the release film 12 from the resin sheet 11) can be achieved.

The encapsulating resin layer 13 is formed from an encapsulating resin composition containing an encapsulating resin.

Examples of the encapsulating resin include a thermoplastic resin that is plasticized by heating, a thermosetting resin that is cured by heating, and an activation energy ray-curable resin that is cured by application of an activation energy ray (e.g., ultraviolet ray, electron beam, etc.).

Examples of thermoplastic resins include vinyl acetate resin, ethylene-vinyl acetate copolymer (EVA), vinyl chloride resin, and an EVA-vinyl chloride resin copolymer.

Examples of the thermosetting resin and the activation energy ray-curable resin include silicone resin, epoxy resin, polyimide resin, phenol resin, urea resin, melamine resin, and unsaturated polyester resin.

As the encapsulating resin, preferably, thermosetting resin is used, and preferably silicone resin is used.

Examples of the encapsulating resin composition containing silicone resin as the encapsulating resin include a thermosetting silicone resin composition such as a two-step curable type silicone resin composition and a one-step curable type silicone resin composition.

The two-step curable type silicone resin composition is a thermosetting silicone resin composition having 2-step reaction mechanism: in the first step reaction, the composition is brought into B-stage (semi-cured), and in the second step reaction, the composition is brought into C-stage (completely cured).

B-stage is a state where the encapsulating resin composition is in between A stage in which the composition is soluble in a solvent and C stage in which the composition is completely cured; curing and gellation progress slightly; the composition swells in the solvent but is not completely dissolved; and the composition softens by heating but does not melt.

Examples of the uncured two-step curable type silicone resin composition (before curing in the first step) include a condensation reaction-addition reaction curable silicone resin composition.

The condensation reaction-addition reaction curable silicone resin composition is a thermosetting silicone resin composition that undergoes condensation reaction and addition reaction by heating, to be more specific, a thermosetting silicone resin composition that undergoes condensation reaction by heating to be brought into B-stage (semi-cured), and then by further heating, undergoes addition reaction (to be specific, for example, hydrosilylation reaction) to be brought into C-stage (completely cured).

Examples of such a condensation reaction-addition reaction curable silicone resin composition include a first condensation reaction-addition reaction curable silicone resin composition containing a polysiloxane having silanol groups at both ends, an alkenyl group-containing trialkoxysilane, organo hydrogen siloxane, a condensation catalyst, and a hydrosilylation catalyst; a second condensation reaction-addition reaction curable silicone resin composition containing a polysiloxane having silanol groups at both ends, an ethylene unsaturated hydrocarbon group-containing silicon compound (hereinafter referred to as ethylene silicon compound), an epoxy group-containing silicon compound, organo hydrogen siloxane, a condensation catalyst, and an addition catalyst (hydrosilylation catalyst); a third condensation reaction-addition reaction curable silicone resin composition containing a silicone oil having silanols at both ends, alkenyl group-containing dialkoxy alkylsilane, organo hydrogen siloxane, a condensation catalyst, and a hydrosilylation catalyst; a fourth condensation reaction-addition reaction curable silicone resin composition containing organopolysiloxane having at least two alkenylsilyl groups in one molecule, organopolysiloxane having at least two hydrosilyl groups in one molecule, a hydrosilylation catalyst, and a curing retarder; a fifth condensation reaction-addition reaction curable silicone resin composition containing a first organopolysiloxane having at least two ethylene unsaturated hydrocarbon groups and at least two hydrosilyl groups in combination in one molecule, a second organopolysiloxane not having an ethylene unsaturated hydrocarbon group but having at least two hydrosilyl groups in one molecule, a hydrosilylation catalyst, and a hydrosilylation retarder; a sixth condensation reaction-addition reaction curable silicone resin composition containing a first organopolysiloxane having at least two ethylene unsaturated hydrocarbon groups and at least two silanol groups in combination in one molecule, a second organopolysiloxane not having an ethylene unsaturated hydrocarbon group but having at least two hydrosilyl groups in one molecule, a hydrosilylation retarder, and a hydrosilylation catalyst; a seventh condensation reaction-addition reaction curable silicone resin composition containing a silicon compound, and a boron compound or an aluminum compound; and an eighth condensation reaction-addition reaction curable silicone resin composition containing polyaluminosiloxane and a silane coupling agent.

These condensation reaction-addition reaction curable silicone resin compositions may be used singly or in a combination of two or more.

As the condensation reaction-addition reaction curable silicone resin composition, preferably, the second condensation reaction-addition reaction curable silicone resin composition is used.

In the second condensation reaction-addition reaction curable silicone resin composition, the polysiloxane having silanol groups at both ends, the ethylene silicon compound, and the epoxy group-containing silicon compound are condensation materials (material subjected to condensation reaction), and the ethylene silicon compound and the organo hydrogen siloxane are addition materials (material subjected to addition reaction).

Meanwhile, the one-step curable silicone resin composition is a thermosetting silicone resin composition having a one-step reaction mechanism, and is completely cured in the first step reaction.

Examples of the one-step curable type silicone resin composition include addition reaction curable silicone resin compositions.

The addition reaction curable silicone resin composition contains, for example, a main component, i.e., ethylene unsaturated hydrocarbon group-containing polysiloxane, and a cross-linking agent, i.e., organo hydrogen siloxane.

Examples of the ethylene unsaturated hydrocarbon group-containing polysiloxane include alkenyl group-containing polydimethylsiloxane, alkenyl group-containing polymethylphenylsiloxane, and alkenyl group-containing polydiphenylsiloxane.

The addition reaction curable silicone resin composition is usually served, with separately packaged ethylene unsaturated hydrocarbon group-containing polysiloxane and organo hydrogen siloxane. To be specific, the addition reaction curable silicone resin composition is served by two components: component A containing a main component (ethylene unsaturated hydrocarbon group-containing polysiloxane), and component B containing a cross-linking agent (organo hydrogen siloxane). Known catalysts that are necessary for the addition reaction of component A and component B are added to ethylene unsaturated hydrocarbon group-containing polysiloxane.

With such an addition reaction curable silicone resin composition, a main component (component A) and a cross-linking agent (component B) are mixed to prepare a mixture solution, and in the step of molding the mixture liquid into the shape of the above-described encapsulating resin layer 13, the ethylene unsaturated hydrocarbon group-containing polysiloxane and organo hydrogen siloxane undergo addition reaction so that the addition reaction curable silicone resin composition is cured, to form a silicone elastomer (cured product).

The encapsulating resin composition may contain, as necessary, a suitable proportion of phosphor and a filler.

Examples of phosphor include yellow phosphor that is capable of converting blue light to yellow light. As such phosphor, a phosphor having composite metal oxide or metal sulfide doped with metal atoms such as cerium (Ce) and europium (Eu) is used.

Specific examples of the phosphor include garnet type phosphors having garnet type crystal structure such as Y₃AlₛO₁₂: Ce (YAG(yttrium aluminum garnet):Ce), (Y,Gd)₃Al₅O₁₂:Ce, Tb₃Al₃O₁₂:Ce, Ca₃Sc₂Si₃O₁₂:Ce, and Lu₂CaMg₂(Si,Ge)₃O₁₂:Ce; silicate phosphors such as (Sr,Ba)₂SiO₄:Eu, Ca₃SiO₄Cl₂:Eu, Sr₃SiO₅:Eu, Li₂SrSiO₄:Eu, and Ca₃Si₂O₇:Eu; aluminate phosphors such as CaAl₁₂O₁₉:Mn and SrAl₂O₄:Eu; sulfide phosphors such as ZnS:Cu,Al, CaS:Eu, CaGa₂S₄:Eu, and SrGa₂S₄:Eu; oxynitride phosphors such as CaSi₂O₂N₂:Eu, SrSi₂O₂N₂:Eu, BaSi₂O₂N₂:Eu, and Ca-α-SiAlON; nitride phosphors such as CaAlSiN₃:Eu and CaSi₅N₈:Eu; and fluoride phosphors such as K₂SiF₆:Mn and K₂TiF₆:Mn. Preferably, garnet type phosphor, and more preferably, Y₃Al₅O₁₂: Ce is used.

Examples of the filler include silicone microparticles, glass, alumina, silica (fused silica, crystalline silica, ultrafine amorphous silica, hydrophobic ultrafine silica, etc.), titania, zirconia, talc, clay, and sulfuric acid barium. These fillers may be used singly or in a combination of two or more. Preferably, silicone microparticles, or silica is used.

To the encapsulating resin composition, for example, known additives such as a modifier, surfactant, dye, pigment, discoloration inhibitor, and ultraviolet absorber can be added in a suitable proportion.

The encapsulating resin layer 13 is, for example, composed of a thermosetting silicone resin composition of before completely cured or after completely cured, and preferably composed of a thermosetting silicone resin composition before completely cured.

More preferably, the encapsulating resin layer 13 is composed of, when the thermosetting silicone resin composition is a two-step curable type silicone resin composition, a lst-step cured material of the two-step curable type silicone resin composition, and when the thermosetting silicone resin composition is a one-step curable type silicone resin composition, an uncured material (before curing) of the one-step curable type silicone resin composition.

Particularly preferably, the encapsulating resin layer 13 is a 1st-step cured material of the two-step curable type silicone resin composition.

To form the encapsulating resin layer 13, for example, the above-described encapsulating resin composition (containing as necessary a fluorescent agent, a filler, etc.) is applied on the release film 12 to give a suitable thickness by a method such as casting, spin coating, and roll coating, and as necessary, heated and dried. The encapsulating resin layer 13 in the form of a sheet can be formed in this manner.

The encapsulating resin layer 13 has a hardness that allows its compressive elastic modulus to be, for example, 0.01 MPa or more, preferably 0.01 to 1.0 MPa, more preferably, 0.04 to 0.2MPa.

The encapsulating resin layer 13 is formed into a size such that the plurality of light-emitting diode elements 2 and the plurality of wires 6 can be encapsulated at once.

The resin sheet 11 has a thickness of, without particular limitation, for example, 100 to 2000 µm, preferably 300 to 1000 µm.

To produce the light-emitting device assembly 1, as shown in FIG. 2 (a), the resin sheet 11 is disposed so that the encapsulating resin layer 13 faces the light-emitting diode element 2 in up-down direction in spaced-apart relation; then, as shown in FIG. 2 (b), the resin sheet 11 is brought down (pressed down), thereby covering the light-emitting diode elements 2 and the wires (not shown) with the encapsulating resin layer 13.

Then, as shown in FIG. 2 (c), the resin sheet 11 is pressure bonded to the semiconductor substrate 9. The pressure bonding is performed, preferably, under a reduced pressure environment.

In the pressure bonding, the amount of the encapsulating resin layer 13 to be pushed (compressed) into the semiconductor substrate 9 side (lower side) is suitably controlled.

The pressure bonding is performed at a temperature of, for example, 0 to 40°C, preferably 15 to 35°C.

In the pressure bonding, as necessary, the resin sheet 11 is kept while being pressed (pushed) down.

The keeping time during the pressure bonding is, for example, 10 seconds to 10 minutes, preferably 10 seconds to 5 minutes.

For the pressure bonding, although not shown, a known pressing apparatus is used.

To produce the light-emitting device assembly 1, as shown in FIG. 2 (d), as necessary (e.g., when the encapsulating resin layer 13 of the resin sheet 11 contains a thermosetting resin), the encapsulating resin layer 13 is cured by heating, to be formed into the encapsulating layer 3.

The curing conditions are such that the thermosetting resin of the above-described encapsulating resin layer 13 is completely cured, or when the encapsulating resin layer 13 contains the condensation-addition reaction curable silicone resin composition, such that the addition reaction (hydrosilylation reaction) progresses.

To be specific, the heating temperature is, for example, 80 to 200°C, preferably 100 to 180°C, and the heating time is, for example, 0.1 to 20 hours, preferably 1 to 10 hours.

Thereafter, by removing the release film 12 from the encapsulating layer 3, production of the light-emitting device assembly 1 is completed.

In the thus obtained light-emitting device assembly 1, as described above, the plurality of light-emitting devices 10 are disposed continuously in one direction, and the encapsulating layers 3 of the light-emitting devices 10 next to each other are disposed so as to make a line contact at one side, and therefore the area (amount used) of the circuit board 4 per one light-emitting device 10 can be reduced, allowing for size and cost reduction.

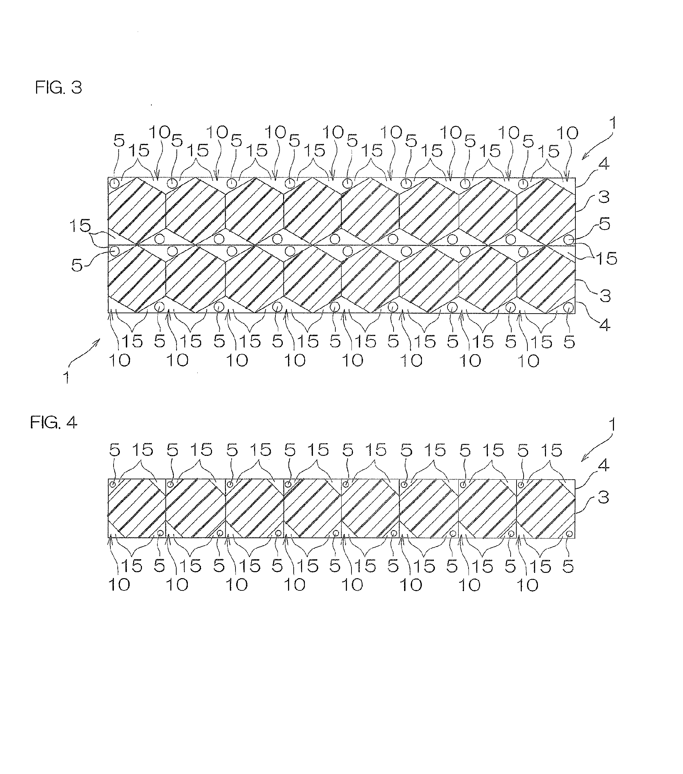

FIG. 3 is a plan view illustrating an embodiment in which the light-emitting device assembly shown in FIG. 1 is formed in a plural number continuously.

The light-emitting device assembly 1 can be formed, for example, as shown in FIG. 3, in a plural number (e.g., two) continuously in the vertical direction. In such a case, a plurality of (e.g., 8 rows × 2 columns) circuit boards 4 can be formed continuously and integrally.

In such a case, the exposed portion 15 defined outside the encapsulating layer 3 is defined at four corners of the circuit board 4 into a generally triangular shape when viewed from the top, and continuously with the exposed portion 15 of the light-emitting device 10 next to each other in the vertical direction and with the exposed portion 15 of the light-emitting device 10 next to each other in the transverse direction, forms a generally rhombic shape when viewed from the top.

Of the exposed portions 15 defined in one light-emitting device 10, on the exposed portion 15 of one side in the vertical direction and one side in the transverse direction, and on the exposed portion 15 of other side in the vertical direction and the other side in the transverse direction, two external electrodes 5 are disposed oppositely so as to sandwich the encapsulating layer 3.

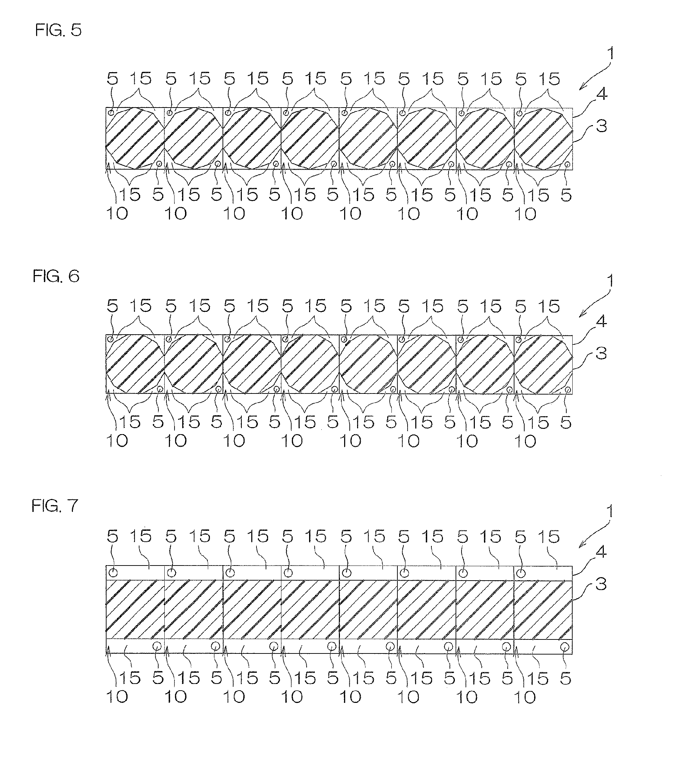

FIG. 4 is a plan view of another embodiment of the light-emitting device assembly of the present invention (embodiment in which the encapsulating layer is formed into a generally regular octagonal shape when viewed from the top), FIG. 5 is a plan view illustrating another embodiment of the light-emitting device assembly of the present invention (embodiment in which the encapsulating layer is formed into a generally regular decagonal shape when viewed from the top), and FIG. 6 is a plan view illustrating another embodiment of the light-emitting device assembly of the present invention (embodiment in which the encapsulating layer is formed into a generally regular dodecagonal shape when viewed from the top).

In the description above, the encapsulating layer 3 is described as having a generally regular hexagonal shape when viewed from the top. However, the shape of the encapsulating layer 3 is not particularly limited, as long as the encapsulating layer 3 of the light-emitting devices 10 next to each other is in contact at at least one point. For example, as shown in FIG. 4, the encapsulating layer 3 can be formed into a generally regular octagonal shape when viewed from the top, and for example, as shown in FIG. 5, can be formed into a generally regular decagonal shape when viewed from the top, and for example, as shown in FIG. 6, can be formed into a generally regular dodecagonal shape when viewed from the top.

When the encapsulating layer 3 is formed in such a fashion as well, the exposed portion 15 is defined outside the encapsulating layer 3, to be specific, at four corners of the circuit board 4, i.e., at both sides in the vertical direction and both sides in the transverse direction. The exposed portion 15 is defined such that the exposed portions 15 of the light-emitting devices 10 next to each other are continuous in the transverse direction.

On the exposed portions 15 defined in one light-emitting device 10, two external electrodes 5 are disposed oppositely so as to sandwich the encapsulating layer 3: one on the exposed portion 15 of one side in the vertical direction and one side in the transverse direction, and one on the exposed portion 15 of the other side in the vertical direction and the other side in the transverse direction.

With such a light-emitting device assembly 1 as well, similarly to the above described case, the area (amount used) of the circuit board per one light-emitting device can be reduced, allowing for size and cost reduction.

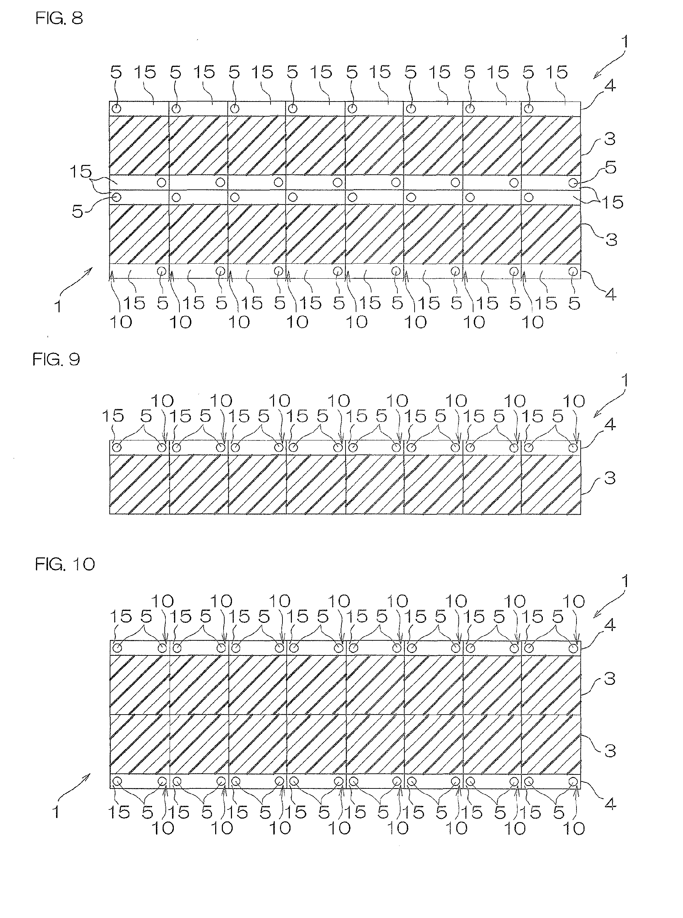

FIG. 7 is a plan view of another embodiment of the light-emitting device assembly of the present invention (embodiment in which the encapsulating layer is formed into a generally rectangular shape when viewed from the top, and the external electrodes are formed so as to sandwich the encapsulating layer), and FIG. 8 is a plan view illustrating an embodiment in which the light-emitting device assembly shown in FIG. 7 is formed in a plural number continuously.

The encapsulating layer 3 can be formed, for example, as shown in FIG. 7, into a generally rectangular shape when viewed from the top.

When the encapsulating layer 3 is formed in such a fashion, the exposed portion 15 is defined outside the encapsulating layer 3, to be specific, at both sides in the vertical direction of the circuit board 4, into a generally rectangular shape when viewed from the top. The exposed portion 15 is defined such that the exposed portions 15 of the light-emitting devices 10 next to each other are continuous in the transverse direction.

On the exposed portion 15 defined in one light-emitting device 10, two external electrodes 5 are disposed oppositely so as to sandwich the encapsulating layer 3: one on the one side in the transverse direction of the exposed portion 15 of one side in the vertical direction, and one on the other side in the transverse direction of the exposed portion 15 of the other side in the vertical direction.

With such a light-emitting device assembly 1 as well, similarly to the above-described case, the area (amount used) of the circuit board per one light-emitting device can be reduced, allowing for size and cost reduction.

Furthermore, for example, as shown in FIG. 8, such a light-emitting device assembly 1 can be formed in a plural number (e.g., two) continuously in the vertical direction.

In such a case, the exposed portion 15 defined outside the encapsulating layer 3 is defined into a generally rectangular shape when viewed from the top at both sides in the vertical direction of the circuit board 4. Furthermore, the exposed portion 15 is defined into a generally rectangular shape when viewed from the top so as to be sandwiched by the exposed portions 15 at the both sides in the vertical direction, at a center portion in the vertical direction (near the boundary of two continuous light-emitting device assemblies 1) of the circuit board 4. The exposed portion 15 is defined so that the exposed portions 15 of the light-emitting devices 10 next to each other continue in the transverse direction.

On the two exposed portions 15 defined in one light-emitting device 10, two external electrodes 5 are disposed to face each other oppositely so as to sandwich the encapsulating layer 3: one on the one side in the transverse direction of the exposed portion 15 of one side in the vertical direction, and one on the other side in the transverse direction of the exposed portion 15 of the other side in the vertical direction.

With such a light-emitting device assembly 1 as well, similarly to the above-described case, the area (amount used) of the circuit board per one light-emitting device can be reduced, allowing for size and cost reduction.

FIG. 9 is a plan view of another embodiment of the light-emitting device assembly of the present invention (embodiment in which the encapsulating layer is formed into a generally rectangular shape when viewed from the top, and the external electrodes are formed so as not to sandwich the encapsulating layer).

In the description above, the pair of external electrodes 5 are formed so that the encapsulating layer 3 is sandwiched therebetween. However, for example, as shown in FIG. 9, the encapsulating layer 3 can be formed into a generally rectangular shape when viewed from the top, and the pair of external electrodes 5 can be formed so that the encapsulating layer 3 is not sandwiched therebetween.

That is, in the light-emitting device assembly 1 shown in FIG. 9, the exposed portion 15 defined at the outside of the encapsulating layer 3 is defined only at one side in the vertical direction (upper side on the plane of the sheet) into a generally rectangular shape when viewed from the top, and the external electrodes 5 are put together so as to be disposed transverse direction in spaced-apart relation at one side in the vertical direction (upper side on the plane of the sheet).

Therefore, compared with the case where the exposed portion 15 is defined at both sides of one side in the vertical direction (upper side on the plane of the sheet) and the other side (lower side on the plane of the sheet), the area (amount used) of the circuit board 4 per one light-emitting device 10 can be further decreased, allowing for size and cost reduction.

FIG. 10 is a schematic plan view illustrating an embodiment in which the light-emitting device assembly shown in FIG. 9 is formed in a plural number continuously.

For example, as shown in FIG. 10, such a light-emitting device assembly 1 can be formed in a plural number (e.g., two) continuously in the vertical direction.

Furthermore, in such a case, the exposed portion 15 of the one side in the vertical direction (upper side on the plane of the sheet) of the light-emitting device assembly 1 is formed at one side (upper side on the plane of the sheet), and the external electrodes 5 are put together at one side (upper side on the plane of the sheet) so as to be disposed in the transverse direction in spaced-apart relation; and the exposed portion 15 of the light-emitting device assembly 1 of the other side (lower side on the plane of the sheet) in the vertical direction is formed at the other side (lower side on the plane of the sheet), and the external electrodes 5 are put together to be disposed at the other side (lower side on the plane of the sheet) in the transverse direction in spaced-apart relation.

In such a case, the exposed portion 15 defined outside the encapsulating layer 3 is defined at both sides in the vertical direction of the circuit board 4 into a generally rectangular shape when viewed from the top. On the other hand, the exposed portion 15 is not defined at a center portion in the vertical direction (near the boundary of the two continuous light-emitting device assemblies 1) of the circuit board 4.

Therefore, in such a case, the encapsulation step by the encapsulating layer 3 is simplified, achieving improvement in yields.

That is, as shown in FIG. 8 above, when the exposed portion 15 is defined at a center portion in the vertical direction (near the boundary of the two continuous light-emitting device assemblies 1) of the circuit board 4, one encapsulating layer 3 has to be used for one light-emitting device assembly 1 (1 column × 8 rows).

On the other hand, as shown in FIG. 10 above, when the exposed portion 15 is not defined at a center portion in the vertical direction (near the boundary of the two continuous light-emitting device assemblies 1) of the circuit board 4, one encapsulating layer 3 can be used for two light-emitting device assemblies 1 (2 columns × 8 rows), and therefore the encapsulation step by the encapsulating layer 3 is simplified, achieving improvement in yields.

The present invention includes a lighting device obtained by using the above-described light-emitting device assembly 1, to be specific, a lighting device including at least one of the above-described light-emitting device 10.

That is, for example, a light-emitting device assembly 1 having a plurality of light-emitting devices 10 continued in a transverse direction (e.g., ref FIG. 1) can be used as is as a lighting device, and a plurality of light-emitting device assemblies 1 disposed continuously in the vertical direction (e.g., ref: FIG. 3) can be used as a lighting device.

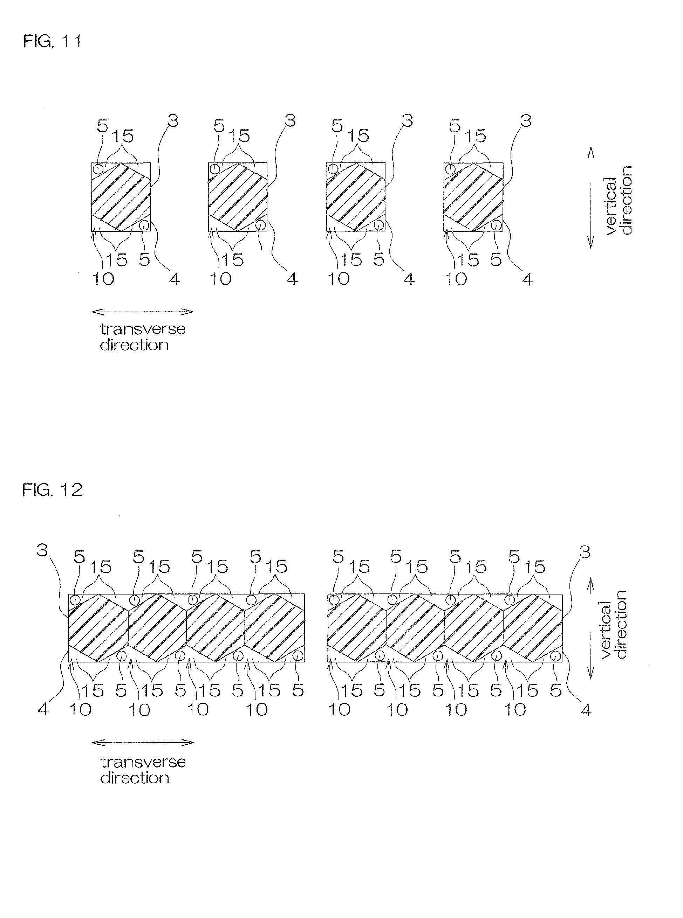

Furthermore, for example, as shown in FIG. 11, a light-emitting device 10 individually separated from the above-described light-emitting device assembly 1 can be used as a lighting device, and in addition, for example, as shown in FIG. 12, a plurality of light-emitting devices 10 separated by groups (e.g., a group of four) can be used as a lighting device.

Such a lighting device can be obtained from the above-described light-emitting device assembly, thus allowing for size and cost reduction.

In the description above, a plurality of light-emitting diode elements 2 are used per one light-emitting device 10; however, depending on use of the light-emitting device 10, the number of the light-emitting diode element 2 is not particularly limited. For example, a single light-emitting diode element 2 may be used for one light-emitting device 10.

## Claims

1. A light-emitting device assembly including a plurality of light-emitting devices,
the plurality of light-emitting devices each comprising:
a circuit board including a pair of electrodes to be connected to an external power source, and to which an electric power is supplied from the power source through the electrodes; a semiconductor element supported on and electrically connected to the circuit board;
and
an encapsulating layer that encapsulates the semiconductor element on the circuit board,
wherein
the plurality of light-emitting devices are disposed so as to be continuous in one direction,
and
the encapsulating layer is disposed so that the encapsulating layers of the light-emitting devices next to each other are in contact with each other when viewed from the top.

2. The light-emitting device assembly according to Claim 1, wherein the encapsulating layer has at least one side when viewed from the top, and the encapsulating layers of the light-emitting devices next to each other are disposed so as to make a line contact at the one side.

3. The light-emitting device assembly according to Claim 1 or 2, wherein the encapsulating layer has a generally polygonal shape when viewed from the top.

4. The light-emitting device assembly according to Claim 1, 2 or 3, wherein the encapsulating layer has a (4+2n)-gon shape when viewed from the top (n is a natural number including 0).

5. The light-emitting device assembly according to Claim 1, 2, 3 or 4, wherein the encapsulating layer has a generally regular hexagonal shape when viewed from the top.

6. A lighting device comprising at least one of a plurality of light-emitting devices of a light-emitting device assembly including the plurality of light-emitting devices, the plurality of light-emitting devices each comprising:
a circuit board including a pair of electrodes to be connected to an external power source, and to which an electric power is supplied from the power source through the electrodes;
a semiconductor element supported on and electrically connected to the circuit board;
and
an encapsulating layer that encapsulates the semiconductor element on the circuit board,
wherein the plurality of light-emitting devices are disposed so as to be continuous in one direction, and
the encapsulating layer is disposed so that the encapsulating layers of the light-emitting devices next to each other are in contact with each other when viewed from the top.
